(19) Europäisches Patentamt
European Patent Office
Office européen des brevets

(11) **EP 1 050 894 B1**

(12) **EUROPÄISCHE PATENTSCHRIFT**

(45) Veröffentlichungstag und Bekanntmachung des Hinweises auf die Patenterteilung:
**06.10.2004 Patentblatt 2004/41**

(51) Int Cl.⁷: **H01H 47/32**, H03K 17/64, B60T 8/00

(21) Anmeldenummer: **00109366.5**

(22) Anmeldetag: **02.05.2000**

(54) **Schaltungsvorrichtung zum Regeln einer induktiven Last**

Circuit for controlling an inductive load

Circuit de commande d'une charge inductive

(84) Benannte Vertragsstaaten:
**FR GB IT**

(30) Priorität: **03.05.1999 DE 19920306**

(43) Veröffentlichungstag der Anmeldung:
**08.11.2000 Patentblatt 2000/45**

(73) Patentinhaber: **STMicroelectronics GmbH**
**85630 Grasbrunn (DE)**

(72) Erfinder: **Schwartz, Reiner**
**85567 Grafing (DE)**

(74) Vertreter: **Hirsch, Peter, Dipl.-Ing.**
**Klunker Schmitt-Nilson Hirsch**
**Winzererstrasse 106**
**80797 München (DE)**

(56) Entgegenhaltungen:
DE-A- 4 434 179          GB-A- 2 081 942
US-A- 4 132 925          US-A- 4 446 410
US-A- 4 967 309          US-A- 5 801 458

## Beschreibung

Die Erfindung betrifft eine Schaltungsvorrichtung zum Regeln einer induktiven Last gemäß Oberbegriff des Anspruchs 1. Eine solche Schaltungsvorrichtung ist aus der GB-A-2 081 942 bekannt. Das Soll-Stromsignal wird von einem an eine eigene Spannungsquelle angeschlossenen Potentiometer geliefert.

Ein spezielles Anwendungsgebiet der Erfindung ist das Regeln einer induktiven Last in Form einer elektromagnetischen Treibervorrichtung für ein Bremsventil einer blockiergeschützten Bremsanlage (ABS). Speziell geht es bei der Erfindung um das Regeln einer induktiven Last mit Hilfe eines PWM-Stellsignals, d.i. ein Stellsignal in Form eines Impulszugs mit einem veränderbaren Tastverhältnis (engl. Duty Cycle DC = Verhältnis von Impulslänge zu Impulspause). Das PWM-Stellsignal (PWM = Pulse Width Modulation; Pulsbreitenmodulation) öffnet und sperrt ein elektronisches Stromschaltelement, welches in dem Stromkreis der induktiven Last liegt.

Üblicherweise ist zu der zu regelnden induktiven Last, die in einem ersten Schaltungszweig liegt, ein zweiter Schaltungszweig mit einer Freilaufdiode parallelgeschaltet. Das elektronische Stromschaltelement befindet sich in einem dritten Schaltungszweig in Reihenschaltung "vor" oder "hinter" dem ersten und dem zweiten Anschluß des ersten und des zweiten Schaltungszweigs. Wenn das elektronische Stromschaltelement abwechselnd öffnet und schließt, fließt ein Strom durch die induktive Last, wenn das Stromschaltelement geöffnet ist, während bei geschlossenem Stromschaltelement durch die Freilaufdiode ein Rückstrom aufgrund der in der induktiven Last gespeicherten Energie fließt.

Will man mit der induktiven Last (zum Beispiel einem Elektromagneten) zum Beispiel einen Fluiddruck regeln, geschieht dies durch Regeln des Stromflusses durch die induktive Last. Hierzu wird der Stromfluß durch die induktive Last gemessen, um ein Ist-Stromsignal zu gewinnen, und dieses Ist-Stromsignal wird mit einem dem gewünschten Strom entsprechenden Soll-Stromsignal verglichen, um anhand des Vergleichsergebnisses ein PWM-Stellsignal für die Ansteuerung des Stromschaltelements zu bilden.

Üblicherweise erfolgt das Feststellen des Stromflusses durch die induktive Last mit Hilfe eines Meßwiderstands, der direkt zu der induktiven Last in Reihe geschaltet ist, oder der in Reihe zu dem elektronischen Stromschaltelement angeordnet ist. Der Meßwiderstand liefert eine Meßspannung. Diese Meßspannung wird verglichen mit einer dem Soll-Stromsignal entsprechenden Referenzspannung. Die Referenzspannung wird von einem Referenzwiderstand geliefert, der in Reihe zu einer veränderlichen Stromquelle geschaltet ist. Mit Hilfe der veränderlichen Stromquelle kann das Soll-Stromsignal an dem Referenzwiderstand gebildet werden, wobei dann die Referenzspannung der gewünschten Stromstärke durch die induktive Last entspricht.

Schaltungsvorrichtungen der hier in Rede stehenden Art werden heute üblicherweise in Form von integrierten Schaltungen ausgebildet. Die zu regelnde induktive Last wird an einen Batteriespannungsanschluß und einen Ausgangsspannungsanschluß angeschlossen. Außer der zu regelnden induktiven Last selbst befinden sich sämtliche oder nahezu sämtliche Schaltungselemente innerhalb der integrierten Schaltung.

Nun entsteht in einer solchen Schaltungsvorrichtung innerhalb des Meßwiderstands eine beträchtliche Verlustleistung, abhängig von dem Tastverhältnis (DC) des PWM-Stellsignals. Bei hohem Tastverhältnis und entsprechend starkem Stromfluß entsteht eine hohe Verlustleistung, die mit Hilfe einer entsprechend großen Chipfläche abgeführt werden muß. Bekanntlich ist die Verlustleistung proportional zu dem Widerstand und außerdem proportional zum Quadrat des Stroms. Eine Stromregelung ist aber unerläßlich aufgrund der starken Temperaturabhängigkeit der ohmschen Widerstandskomponente der induktiven Last. Dies gilt für wenn nicht sämtliche, so doch die meisten Anwendungsfälle der hier in Rede stehenden Art.

Die Abhängigkeit der Verlustleistung im Meßwiderstand von dem Tastverhältnis des PWM-Stellsignals entspricht einer monoton ansteigenden Kurve. Praktisch nutzbar ist der Bereich zwischen 10 % und 90 %. Um insbesondere im unteren Meßbereich eine relativ hohe Genauigkeit zu erhalten, ist ein hoher Widerstandswert für den Meßwiderstand erforderlich. Die Meßgenauigkeit im unteren Bereich ist in den meisten Anwendungsfällen von besonderer Bedeutung. Bei einem etwa linearen Anstieg der Verlustleistung in Abhängigkeit vom Tastverhältnis ist aber im unteren Meßbereich die Meßgenauigkeit relativ gering, während im oberen Meßbereich erhebliche Verlustleistung entsteht.

Der Erfindung liegt die Aufgabe zugrunde, eine Schaltungsvorrichtung zum Regeln einer induktiven Last anzugeben, die bei vorgegebenem Wert des Meßwiderstands eine im Vergleich zum Stand der Technik geringere Verlustleistung im Meßwiderstand aufweist, bzw. die bei vorgegebener Verlustleistung mit einer vergleichsweise geringen Chipfläche auskommt. Bei vorgegebener maximaler Verlustleistung soll der Wert des Meßwiderstands erhöht werden können, um dadurch insbesondere im unteren Meßbereich eine erhöhte Meßgenauigkeit zu erzielen.

Hierzu schafft die Erfindung eine Schaltungsvorrichtung zum Regeln einer induktiven Last, die die Merkmale des Anspruchs 1 aufweist.

Vorzugsweise ist der Stromfühler ein ohmscher Meßwiderstand, der zu der Freilaufdiode in dem zweiten Schaltungszweig in Reihe geschaltet ist. Das Soll-Stromsignal wird erfindungsgemäß in einem vierten Schaltungszweig gebildet, der an dem zweiten Schaltungszweig angeschlossen ist und einen Referenzwiderstand sowie eine insbesondere veränderliche Stromquelle enthält. Der durch die Stromquelle festgelegte Strom erzeugt an dem Referenzwiderstand eine Referenzspannung, die das Soll-Stromsignal darstellt. Dieses Soll-Stromsignal wird mit dem Ist-Stromsignal in Form der an dem Meßwiderstand entstehenden Meßspannung verglichen, um ein Abweichungssignal zu erhalten, welches in einer bevorzugten Ausgestaltung der Erfindung als Vorzeichensignal erzeugt wird. Dieses Vorzeichensignal wird dann weiterverarbeitet, um das PWM-Stellsignal zu erhalten.

Bei einem ohmschen Meßwiderstand ändert sich die Meßspannung proportional zu der Stromstärke. Man erhält relativ genaue Meßergebnisse.

In einer speziellen Ausführungsform der Erfindung wird der Stromfühler durch ein Bauelement mit einer nichtlinearen Kennlinie gebildet, zum Beispiel durch eine Diode. Entsprechend der Dioden-Kennlinie ist dann das Referenzelement in dem vierten Schaltungszweig ein Element mit einer dem Stromfühler entsprechenden Kennlinie, also hier insbesondere einer Referenzdiode. Meßdiode und Referenzdiode werden mit im wesentlichen gleichen Kennlinien ausgebildet. Da gleiche Kennlinien nicht so einfach zu erreichen sind, eignet sich diese Ausführungsform speziell für solche Anwendungen, in denen eine relativ große Toleranz zulässig ist. Als Meßdiode kann man auch die Freilaufdiode selbst verwenden.

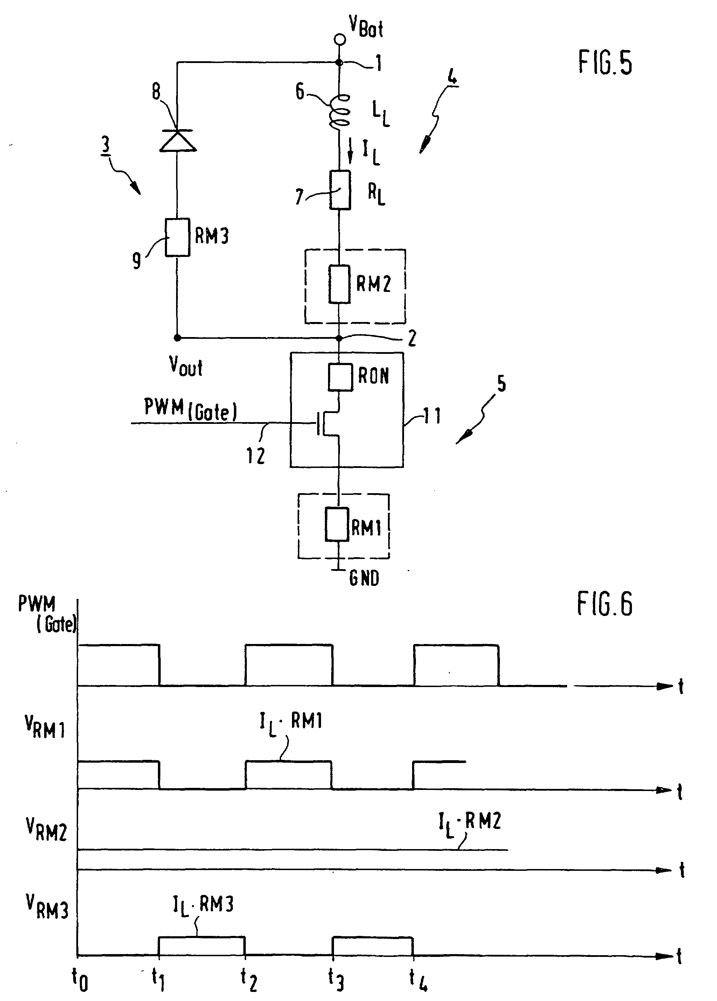

Bevor spezielle Ausführungsbeispiele der Erfindung beschrieben werden, soll zur Verdeutlichung der Unterschiede zwischen der Erfindung einerseits und dem Stand der Technik einerseits anhand der Figuren 5, 6 und 8 die Bedeutung der Maßnahme erläutert werden, den Stromfühler in dem zweiten Schaltungszweig, also in dem Parallelkreis der zu regelnden induktiven Last anzuordnen.

Gemäß Fig. 5 befindet sich zwischen einem ersten Anschluß 1, der auf der Batteriespannung $V_{Bat}$ liegt, und einem zweiten Anschluß 2, an welchem eine Spannung $V_{out}$ liegt, ein erster Schaltungszweig 4, der eine zu regelnde induktive Last enthält, hier bestehend aus einer Induktivität 6, die mit einer ohmschen Widerstandskomponente 7 behaftet ist.

An den zweiten Anschluß 2 ist ein dritter Schaltungszweig 5 angeschlossen. Der dritte Schaltungszweig 5 enthält ein elektronisches Schaltelement 11, hier zum Beispiel als MOSFET ausgebildet. Die Source-Drain-Strecke leitet oder sperrt den Stromfluß durch den dritten Schaltungszweig 5 in Abhängigkeit eines PWM-Stellsignals PWM (Gate), welches einem Steueranschluß 12 des Stromschaltelements 11 zugeführt wird. Im geöffneten, das heißt eingeschalteten Zustand des Stromschaltelements wirkt ein Einschaltwiderstand Ron in Serie innerhalb des dritten Schaltungszweigs 5. Die Spannung $V_{out}$ an dem zweiten Anschluß 2 ändert sich sprunghaft in Abhängigkeit des PWM-Signals. Wenn das Stromschaltelement 11 geöffnet ist, entspricht $V_{out}$ etwa der Spannung an dem dritten Anschluß GND. Wenn das Stromschaltelement 11 gesperrt ist, liegt die Spannung $V_{out}$ am Anschluß 2 über der Batteriespannung $V_{Bat}$, was weiter unten noch näher erläutert wird.

Fig. 6 zeigt in der obersten Zeile das PWM-Stellsignal PWM (Gate). Unten in Fig. 5 ist gestrichelt ein Meßwiderstand RM1 dargestellt, der sich zwischen dem Stromschaltelement 11 und dem dritten Anschluß GND befindet, wie es aus dem Stand der Technik bekannt ist. Die zweite Zeile in Fig. 6 zeigt den Verlauf der Meßspannung $V_{RM1}$ an dem Meßwiderstand RM1 in Abhängigkeit des PWM-Signals. Hat das PWM-Signal hohen Pegel (z.B. 5V), so ist der elektronische Stromschalter 11 leitend, und aufgrund des Stromflusses entsteht an dem Meßwiderstand RM1 die Spannung $V_{RM1}$. Die Leistung beträgt dann $I_L^2$ * RM1. Über die Periodendauer gemittelt, hängt die Leistung von dem Tastverhältnis (DC = dutycycle) ab.

Fig. 5 zeigt eine Alternative zu der Anordnung des Meßwiderstands. Zwischen dem zweiten Anschluß 2 und dem Widerstand 7 befindet sich ein Meßwiderstand RM2, der in einem gestrichelten Kästchen dargestellt ist, um anzudeuten, daß er - ebenso wie der Meßwiderstand RM1 - nicht tatsächlich in der Schaltung enthalten ist, sondern nur eine dem Stand der Technik entsprechende Möglichkeit darstellt. In dem Meßwiderstand RM2 fließt sowohl ein Strom bei geöffnetem Stromschalter 11 als auch ein Strom bei geschlossenem Stromschalter 11. Letztgenannter Rückstrom bei gesperrtem Stromschalter 11 fließt aus der Induktivität 6 durch den Widerstand 7 und den Meßwiderstand RM1 in einen zweiten Schaltungszweig 3, der zu dem ersten Schaltungszweig 4 parallelgeschaltet ist. Der zweite Schaltungszweig 3 enthält eine Freilaufdiode (flyback diode) 8. Der Stromfluß durch den Meßwiderstand RM2 führt zu einer Spannung $V_{RM2}$, die in der dritten Zeile der Fig. 6 dargestellt ist. Die entsprechende Leistung beträgt $I_L^2$ * RM2.

Der Meßwiderstand RM3, der das Bezugszeichen 9 in dem zweiten Schaltungszweig 3 trägt, entspricht der vorliegenden Erfindung. Eine Meßspannung $V_{RM3}$ entsteht an dem Meßwiderstand RM3, wenn das Stromschaltelement 11 gesperrt ist, wie aus dem Vergleich der ersten und der letzten Zeile in Fig. 6 ersichtlich ist. Die Verlustleistung in dem Meßwiderstand RM3 beträgt $I_L^2$ * RM3.

Im folgenden sollen die Verlustleistungen in dem erfindungsgemäß angeordneten Meßwiderstand RM3 einerseits und den beiden alternativen Meßwiderständen RM2 und RM3 gemäß Stand der Technik andererseits näher untersucht werden.

Die maximale Verlustleistung im Meßwiderstand RM1 beträgt

$$P_{MAX} = I_L^2 * RM1 * DC \qquad (1)$$

Die maximale Verlustleistung im zweiten Meßwiderstand RM2 beträgt

$$P_{MAX} = I_L{}^2 * RM2 \tag{2}$$

Die Verlustleistung in dem erfindungsgemäß angeordneten Meßwiderstand RM 3 beträgt

$$P_{RM3} = I^2 * RM3(1-DC) \tag{3}$$

Der entsprechend der Regelung in der Nähe des Sollwerts schwankende Strom $I_L$ beträgt in dem ersten und dem zweiten Schaltungszweig 4 bzw. 3:

$$I_L = \frac{V_{Bat}}{R_L + R_{ON}} * DC \tag{4}$$

Durch Einsetzen der Gleichung (4) in die Gleichung (3) erhält man

$$P_{RM3} = \left(\frac{V_{Bat}}{R_L+R_{ON}}\right)^2 * DC^2 * RM3 \, (1-DC) \tag{5a}$$

$$= \frac{V_{Bat}*RM3}{(R_L+R_{ON})}2 \; (DC^2-DC^3) \tag{5b}$$

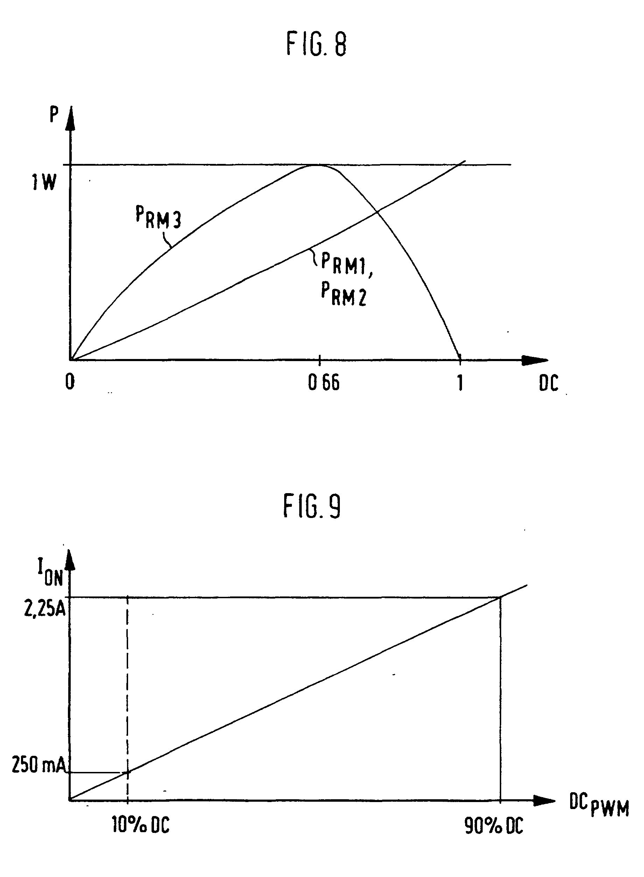

Der Verlauf der Leistung $P_{RM3}$ in Abhängigkeit des Tastverhältnisses DC ist in Fig. 8 dargestellt. Differenziert man die obige Gleichung (5b) nach DC, so ergibt sich

$$\frac{dP_{RM3}}{d_{DC}} = \frac{V_{Bat}^2+RM^3}{(R_L+R_{ON})}2 \; (2DC-3DC^2) \tag{6}$$

Aus

$$2DC - 3DC^2 = 0 \tag{7}$$

ergibt sich neben der trivialen Lösung

$$DC_1 = 0 \tag{8}$$

der Wert

$$DC_2 = 2/3 = 66 \, \% \tag{9}$$

In Fig. 8 ist außer dem Kurvenverlauf für $P_{RM3}$ in Abhängigkeit von DC auch noch der etwa lineare Verlauf von $P_{RM1}$ und $P_{RM2}$ dargestellt. Man sieht, daß die maximale Verlustleistung für die Meßwiderstände RM1 und RM2 erst bei maximalem Tastverhältnis DC erreicht wird, mit Hilfe des erfindungsgemäß angeordneten Meßwiderstands RM3 aber schon bereits bei einem DC-Wert von 0,66 oder 66 % erreicht wird.

Aus der Fig. 8 und dem oben Gesagten läßt sich folgendes herleiten: Wenn man den unteren Meßbereich, hier unterhalb von DC-Werten von etwa 0,6, betrachtet, so ergibt sich dort ein wesentlich steilerer Anstieg der Kurve für $P_{RM3}$ verglichen mit dem linearen Verlauf für $P_{RM1}$ oder $P_{RM2}$. Bei vorgegebener maximaler Verlustleistung (zum Beispiel 1W) erhält man also durch die erfindungsgemäße Maßnahme eine wesentliche höhere Meßgenauigkeit in dem unteren, wichtigen Meßbereich.

Bei vorgegebenem Widerstandswert für den Meßwiderstand ließe sich bei vergleichbarer Empfindlichkeit mit einem geringeren Widerstandswert arbeiten. Die parabelähnliche Kurve für $P_{RM3}$ würde dann im unteren Bereich der DC-Werte etwa parallel zu der Geraden für RM1 und RM2 verlaufen, seinen Maximum-Wert aber bereits unterhalb des in Fig. 8 dargestellten Maximalwerts erreichen.

Ein geringerer Wert für den Widerstand von RM3 bedeutet also weniger Verlustleistung und entsprechend weniger Chipfläche.

Die Erfindung läßt sich in einer Reihe verschiedener Ausführungsformen implementieren, wobei diese Ausführungsformen zum Teil auch losgelöst von der oben ausführlich erläuterten Maßnahme der Anordnung des Meßwiderstands in dem Parallelkreis der induktiven Last neue Elemente enthalten. Wesentlicher Bestandteil der Schaltungsvorrichtung zum Regeln einer induktiven Last ist die Bildung des Abweichungssignals aus dem Ist-Stromsignal und dem Soll-Stromsignal in Verbindung mit der Erzeugung des PWM-Stellsignals. In einer sehr einfach zu realisierenden Ausführungsform sieht die Erfindung ein RS-Flipflop vor, dessen Setzeingang das Vorzeichensignal zugeführt, dessen Rücksetzeingang ein Taktsignal zugeführt wird, und dessen Ausgang mit dem Steueranschluß des Stromschaltelements verbunden ist. Das Vorzeichensignal wird durch Vergleichen der an dem Referenzwiderstand durch das Stromquellensignal gebildeten Referenzspannung und der an dem Meßwiderstand entstehenden Meßspannung erzeugt.

Dem RS-Flipflop wird bei der Ausführungsform der Erfindung einerseits das Vorzeichensignal zum Setzen des Flipflops und andererseits das Taktsignal zum Rücksetzen des Flipflops zugeführt. Das Taktsignal besitzt eine gewisse Frequenz, die die Schaltfrequenz für das Stromschaltelement vorgibt. Die Einschaltdauer des Stromschaltelements, also das Tastverhältnis, hängt ab von dem Vorzeichensignal, also von dem Verhältnis des Ist-Stromsignals zu dem Soll-Stromsignal. Ist der Ist-Strom zu schwach, muß zur Erhöhung des Stroms das Stromschaltelement länger geöffnet werden. Ein zu geringer Strom führt zu einer entsprechend niedrigen Meßspannung an dem Vergleicher, so daß das Vorzeichensignal am Setzeingang des RS-Flipflops relativ früh erscheint und somit das Tastverhältnis vergrößert. Mit einer solchen Schaltung wird ein Einregeln des die induktive Last durchfließenden Stroms auf einen Minimumwert erreicht. Bei Erreichen des Minimumwerts entsprechend dem von der Stromquelle gelieferten Strom erfolgt ein Umschalten des PWM-Stellsignals zum Öffnen des Stromschaltelements.

Eine wesentliche raschere und genauere Regelung läßt sich durch eine andere Ausführungsform der Erfindung erreichen. Diese andere Ausführungsform der Erfindung sieht vor:

a) einen Auf/Ab-Zähler mit einem Auf/Ab-Steuereingang, dem das Vorzeichensignal zugeführt wird, und mit einem Takteingang, dem ein Taktsignal mit einer ersten Frequenz zugeführt wird, und mit einem Zählerstands-Ausgang;

b) einen Rampenzähler mit einem Takteingang, dem ein Taktsignal mit einer zweiten Frequenz zugeführt wird, und mit einem Zählerstands-Ausgang; und

c) einen Digitalvergleicher, mit einem ersten Eingang, der mit dem Zählerstands-Ausgang des Auf/Ab-Zählers verbunden ist, mit einem zweiten Eingang, der mit dem Zählerstandsausgang des Rampenzählers verbunden ist, und mit einem Ausgang, der mit dem Steueranschluß des Stromschaltelements verbunden ist.

Durch die Taktfrequenzen zählt der Auf/Ab-Zähler, wobei sich sein Inhalt nach oben und nach unten ändert in Abhängigkeit des ihm zugeführten Vorzeichensignals. Der Rampenzähler zähltrelativ schnell von einem Minimumwert (zum Beispiel 0) bis zu einem Maximumwert, wobei sein Zählerstand einem Rampensignal entspricht, um dann nach Erreichen des Maximumwerts auf den Minimumwert zurückgeschaltet zu werden und den Zählvorgang erneut zu beginnen. In Verbindung mit dem Vergleicher erreicht man im Ergebnis etwas ähnliches wie durch einen Vergleich einer sich langsam ändernden Spannung oder einer Gleichspannung mit einem Sägezahnsignal: am Ausgang des Vergleichers entsteht je nach Vorzeichenlage der beiden Eingangssignale am Vergleicher entweder ein Signal mit hohem Pegel oder ein Signal mit niedrigem Pegel. Dieses Signal ist das dem Steueranschluß des Stromschaltelements zugeführte PWM-Stellsignal.

Bei dem Taktsignal für den Rampenzähler, also bei dem Taktsignal mit der zweiten Frequenz, kann es sich um einen starren Systemtakt handeln.

In einer bevorzugten Ausgestaltung der Erfindung wird zum Ansteuern des Auf/Ab-Zählers kein Taktsignal mit konstanter, erster Frequenz verwendet, sondern ein Taktsignal mit veränderlicher Frequenz, wobei diese veränderliche erste Frequenz für den Auf/Ab-Zähler umso höher ist, je stärker die Abweichung zwischen Soll-Stromsignal und Ist-Stromsignal ausfällt. Bei einer starken Regelabweichung liefert hierzu in einer besonderen Ausführungsform der Erfindung ein spannungsgesteuerter Oszillator ein in der Frequenz veränderliches Signal, wozu der spannungsgesteuerte Oszillator an seinen zwei Einganganschlüssen das Ist-Stromsignal bzw. das Soll-Stromsignal empfängt und mit seinem Ausgang an den Takteingang des Auf/Ab-Zählers angeschlossen ist. Bei hoher Regelabweichung liefert der spannungsgesteuerte Oszillator (VCO) ein Taktsignal mit relativ hoher Frequenz, so daß der Auf/Ab-Zähler relativ schnell zählt, um dann bei Annäherung von Soll-Stromsignal und Ist-Stromsignal mit einem dann relativ niederfrequenten Taktsignal zu zählen. Durch diese Maßnahme, für die selbständiger Schutz in Verbindung mit solchen Steuer- und Regelschaltungen beansprucht wird, die eine Regelschaltung mit getaktetem Zähler enthalten, wird eine besonders rasche und dennoch genaue Regelung der Stromstärke in der induktiven Last erreicht, ohne daß es zu starken Überschwingern kommt.

Um den Zählvorgang in dem Auf/Ab-Zähler mit dem Öffnen und dem Schließen des Stromschaltelements zu synchronisieren, ist in einer bevorzugten Ausgestaltung der Erfindung dem Takteingang des Auf/Ab-Zählers ein Gatter vorgeschaltet, welches von dem negierten PWM-Stellsignal geöffnet wird.

Die oben erläuterte Ausgestaltung der erfindungsgemäßen Schaltvorrichtung mit einem Auf/Ab-Zähler in Verbindung mit einem Rampenzähler läßt sich zur Verbesserung des Regelverhaltens noch weiter verfeinern, und zwar durch:

a) einen ersten, als I- oder Integral-Zähler bezeichneten Auf/Ab-Zählerteil;

b) einen zweiten, als P- oder Proportional-Zähler bezeichneten Auf/Ab-Zählerteil;

c) ein PWM-Register mit einem Eingang und einem Ausgang; und

d) einen Addierer mit zwei Eingängen, die an den Ausgang des I-Zählerteils bzw. an den Ausgang des P-Zählerteils angeschlossen sind, und mit einem Ausgang, der an den Eingang des PWM-Registers angeschlossen ist,

e) wobei der Ausgang des PWM-Registers an den Eingang des Digitalvergleichers angeschlossen ist, dem Takteingang des P-Zählerteils das Taktsignal mit der ersten Frequenz zugeführt wird, dem Takteingang des I-Zählerteils ein Taktsignal mit einer dritten Frequenz, die vorzugsweise niedriger ist als die erste Frequenz, zugeführt wird, und wobei der P-Zählerteil einen Rücksetz-Eingang aufweist, der mit dem Rampenzähler verbunden ist und von diesem bei jeder Rampenperiode ein Rücksetzsignal empfängt.

Vorzugsweise wird das Taktsignal des I-Zählerteils aus dem Taktsignal des P-Zählerteils durch Frequenzteilung gebildet. Durch die Aufteilung des Auf-/Ab-Zählers in einen I-Zählerteil, der relativ langsam getaktet wird, und einen P-Zählerteil, der relativ schnell getaktet wird, wird ein PI-Regelverhalten erreicht. Der P-Anteil sorgt für eine rasche Annäherung des Ist-Stroms an den Soll-Strom, während der I-Zählerteil für eine Beruhigung des Regelverhaltens sorgt.

Je nach Verarbeitung des durch den Vergleich von Soll-Stromsignal und Ist-Stromsignal erhaltenen Abweichungssignals ist einerseits die Möglichkeit denkbar, innerhalb jeder Periodendauer des PWM-Stellsignals nur eine konstante Meßzeit vorzusehen. Andererseits kann man die Meßzeit über die gesamte Zeitspanne erstrecken, innerhalb der ein Strom durch den Meßwiderstand fließt. Eine solche Meßzeit entspricht dann im wesentlichen der Impulspause des PWM-Stellsignals. Damit hängt aber die Meßzeit ab von dem jeweiligen Tastverhältnis DC des PWM-Stellsignals. Ist die Meßzeit kurz, so werden bei Verwendung eines getakteten Zählers innerhalb einer solchen kurzen Meßzeit nur relativ wenig Impulse gezählt, während bei längerer Meßzeit entsprechend mehr Impulse gezählt werden. Um hierbei Meßfehler zu vermeiden, ist gemäß einer speziellen Weiterbildung der Erfindung eine Meßzeitkompensation vorgesehen. Die Meßzeitkompensation erfolgt mit Hilfe einer Meßzeit-Kompensationsschaltung, die das Taktsignal der ersten Frequenz, welches dem Takteingang des Auf/Ab-Zählers zugeführt wird, in Abhängigkeit des Tastverhältnisses des PWM-Stellsignals in der Weise untersetzt, daß bei großem Tastverhältnis, mithin bei langer Meßzeit, eine relativ starke Untersetzung erfolgt, und bei kleinem Tastverhältnis nur eine relativ schwache Untersetzung erfolgt. Demnach wird also bei langer Meßzeit mit relativ langsamem Takt gezählt, bei relativ kurzer Meßzeit mit entsprechend schnellerem Takt. Durch entsprechende Wahl des Untersetzungsverhältnisses für längere Meßzeiten läßt sich erreichen, daß von der Meßzeit unabhängige Zählvorgänge stattfinden. In einer bevorzugten Ausführungsform der Erfindung weist die Meßzeit-Kompensationsschaltung auf:

a) einen rücksetzbaren Zähler mit einem Eingang, der ein Eingangstaktsignal mit einer Eingangsfrequenz empfängt, mit einem Zählerausgang und mit einem Rücksetzeingang;

b) ein Divisor-Register mit einem Ausgang und einem Setzeingang, über den ein Digitalwert in dem Divisor-Register einstellbar ist, der im umgekehrten Verhältnis zu dem Tastverhältnis des PWM-Stellsignals steht, und

c) eine Teilerschaltung mit einem Dividendeneingang, der mit dem Ausgang des Zählers verbunden ist, mit einem Divisor-Eingang, der mit dem Ausgang des Divisor-Registers verbunden ist, und mit einem Ausgang, der das Taktsignal mit der ersten Frequenz an den Takteingang des Auf/Ab-Zählers gibt.

Dieser Aufbau der Meßzeit-Kompensationsschaltung ist vergleichsweise einfach und liefert die richtigen Mengen von Zählimpulsen an den Auf/Ab-Zähler, unabhängig von der Meßzeit bzw. von dem Tastverhältnis des PWM-Stellsignals.

Im folgenden werden Ausführungsbeispiele der Erfindung anhand der Zeichnungen näher erläutert. Es zeigen:

Fig. 1             eine Schaltungsskizze einer Schaltungsvorrichtung zum Regeln einer induktiven Last gemäß einer ersten Ausführungsform der Erfindung;

Fig. 2             ein Blockschaltbild einer ersten Version der ersten Ausführungsform der Erfindung;

Fig. 3             ein Impulsdiagramm zur Veranschaulichung der Arbeitsweise der Ausführungsform nach den Fig. 1 und 2;

Fig. 4             ein Blockdiagramm einer zweiten Version der ersten Ausführungsform der Erfindung;

Fig. 5             ein Blockdiagramm zur Veranschaulichung des Grundprinzips der Schaltungsvorrichtung gemäß der Erfindung;

Fig. 6             ein Impulsdiagramm zum Erläutern der Arbeitsweise der Schaltung nach Fig. 5;

Fig. 7             ein Blockdiagramm einer zweiten Ausführungsform der erfindungsgemäßen Schaltungsvorrichtung in einer ersten Version;

Fig. 8             eine grafische Darstellung der Verlustleistung in einem Meßwiderstand in Abhängigkeit des Tastverhältnisses DC des PWM-Stellsignals für die Schaltung nach Fig. 5;

Fig. 9             die Abhängigkeit des Einschaltstroms eines Stromschaltelements der Schaltung nach Fig. 5 in Abhängigkeit des Tastverhältnisses des PWM-Stellsignals;

Fig. 10            ein Blockschaltbild einer zweiten Version der zweiten Ausführungsform der Erfindung;

Fig. 11A und 11B    jeweils eine anschauliche, über der Zeitachse aufgetragene Darstellung zum Erläutern des Regelverhaltens der Schaltung nach Fig. 10;

Fig. 12            ein Impulsdiagramm zur Veranschaulichung des Regelverhaltens der Schaltungsvorrichtung nach Fig. 10;

Fig. 13            ein Blockschaltbild einer Meßzeit-Kompensationsschaltung des zweiten und des vierten Schaltungszweigs gemäß Fig. 1;

Fig. 14            ein Impulsdiagramm zur Erläuterung der Arbeitsweise der Schaltung nach Fig. 13; und

Fig. 15            ein Schaltbild für eine alternative Ausführungsform.

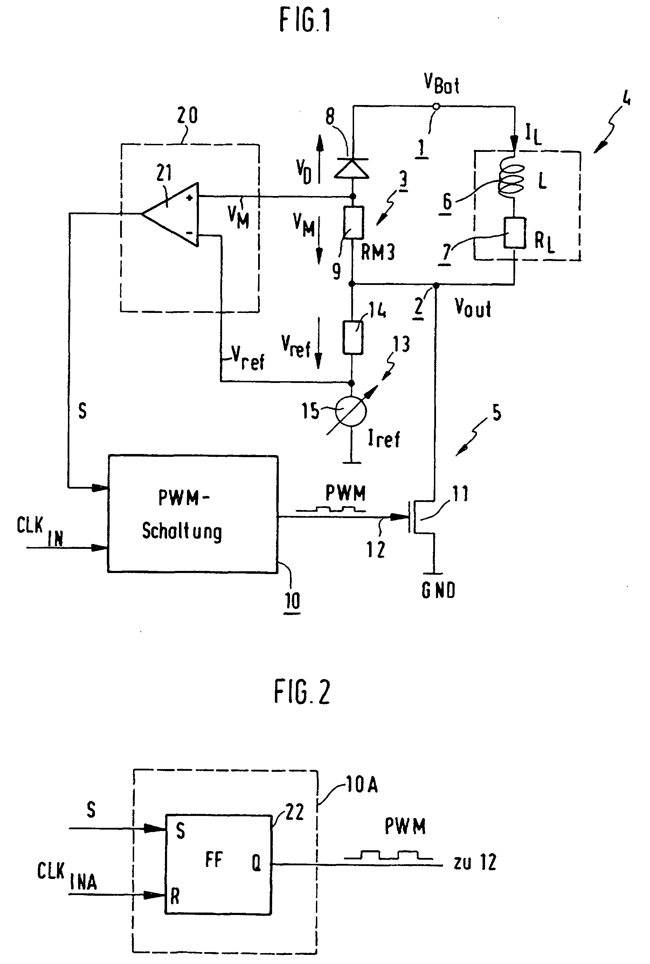

Es wurde oben bereits des Grundprinzip der erfindungsgemäßen Schaltungsvorrichtung zum Regeln einer induktiven Last in Verbindung mit Fig. 5, 6 und 8 erläutert. Die in Fig. 5 gezeigten Schaltungselemente finden sich wieder in der in Fig. 1 gezeigten Schaltungsvorrichtung, die eine erste grundlegende Ausführungsform der Erfindung zeigt. Die bereits in Verbindung mit Fig. 5 erläuterten Komponenten werden nicht noch einmal erläutert. Zur Erinnerung sei lediglich gesagt, daß die im rechten Teil der Fig. 1 dargestellte Schaltung etwa der Schaltung nach Fig. 5 ähnelt und einen ersten Schaltungszweig 4 mit einer zu regelnden induktiven Last 6 und einem dazugehörigen ohmschen Widerstand 7, einen zweiten Schaltungszweig 3 mit einer Freilaufdiode 8 und einen dritten Schaltungszweig 5 mit einem elektronischen Schaltelement 11 enthält. Das Schaltelement 11 ist hier zum Beispiel ein MOSFET mit einem Steueranschluß 12.

Die Schaltungszweige 4 und 3 liegen zueinander parallel zwischen einem ersten Anschluß 1 ($V_{Bat}$) und einem zweiten Anschluß 2 ($V_{out}$), der dritte Schaltungszweig 5 liegt zwischen dem zweiten Anschluß 2 und einem dritten Anschluß GND (Masse).

Zum Regeln des Stroms in der induktiven Last, die die Induktivität 6 mit dem Wert L und eine ohmsche Widerstandskomponente mit dem Wert $R_L$ enthält, wird der Stromfluß durch die Last nach Maßgabe eines PWM-Stellsignals am Steueranschluß 12 des Stromschalters 11 ein- und ausgeschaltet. Beim Ausschalten des Stromschalters 11 wird der Stromfluß durch den dritten Schaltungszweig 5 gesperrt. Aufgrund der in der Induktivität gespeicherten Energie fließt nun der Strom $I_L$ durch den zweiten Schaltungszweig 3, weil und solange die Schaltung an dem zweiten Anschluß 2, also $V_{out}$, höher ist als die Spannung $V_{Bat}$ (hierbei ist die Durchlaßspannung der Freilaufdiode 8 unberücksichtigt). Der Freilaufstrom durch die dann geöffnete Freilaufdiode 8 fließt auch durch den Meßwiderstand 9 oder RM3 und führt zu einer Meßspannung $V_M$.

An den zweiten Anschluß 2 ist ein vierter Schaltungszweig 13 angeschlossen, der eine veränderliche Stromquelle 15 und einen Referenzwiderstand 14 enthält. Die Stromquelle 15 liefert einen einstellbaren Referenzstrom Iref, der an dem Referenzwiderstand 14 zu einer Spannung Vref führt. Die Meßspannung $V_M$ und die Referenzspannung Vref werden einem Vergleicher 20 zugeführt, der hier einen OP-Verstärker 21 enthält, und zwar wird die Meßspannung $V_M$ dem nicht-invertierenden Eingang zugeführt, während die Referenzspannung Vref dem invertierenden Eingang zugeführt wird.

Das Ausgangssignal S des Vergleichers ist ein Vorzeichensignal mit entweder hohem oder niedrigem Pegel. Der Pegel gibt an, ob das Signal $V_M$ größer als Vref ist, oder umgekehrt. Das Vorzeichensignal S wird einer PWM-Schaltung 10 zugeführt, die außerdem ein Eingangs-Taktsignal $CLK_{IN}$ empfängt. Das Taktsignal $CLK_{IN}$ bestimmt die Periodendauer des PWM-Stellsignals am Ausgang der PWM-Schaltung 10, welches dem Steueranschluß 12 des Stromschalters 11 zugeführt wird.

Fig. 2 zeigt eine erste spezielle Version der in Fig. 1 gezeigten Ausführungsform der erfindungsgemäßen Schaltungsvorrichtung. Gemäß Fig. 2 ist dort die PWM-Schaltung 10A als RS-Flipflop 22 mit einem Setzeingang S, einem Rücksetzeingang R und einem Ausgang Q ausgebildet.

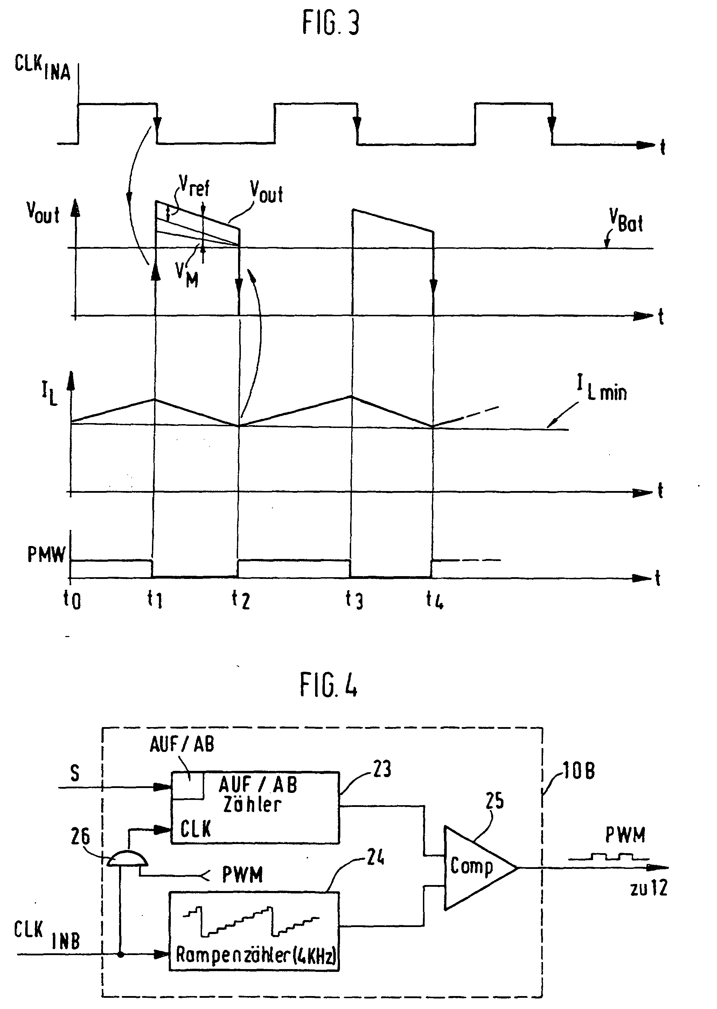

Im folgenden wird die Arbeitsweise der Schaltung nach den Fig. 1 und 2 in Verbindung mit dem in Fig. 3 gezeigten Impulsdiagramm näher erläutert.

In der obersten Zeile in Fig. 3 ist das Taktsignal $CLK_{IN}$ dargestellt. Das Signal besitzt eine feste Periodendauer, die die Periodendauer des PWM-Stellsignals am Anschluß 12 des Stromschalters 11 festlegt. Bei jeder Rückflanke des Taktsignals $CLK_{INA}$ wird das RS-Flipflop 22 zurückgesetzt, so daß dessen Ausgang Q einen niedrigen Pegel hat. Durch diesen niedrigen Pegel des PWM-Stellsignals am Steueranschluß 12 wird das Stromschaltelement 11 gesperrt. Gemäß der zweiten Zeile in Fig. 3 springt die Spannung Vout von einem Wert Null auf einen oberhalb der Spannung $V_{Bat}$ liegenden Wert. Dies geschieht im Zeitpunkt t1 (vergl. die unterste Zeile in Fig. 3, in der das PWM-Stellsignal dargestellt ist). Die Spannung Vout im Zeitpunkt t1 setzt sich zusammen aus der Spannung $V_{Bat}$ zuzüglich der Meßspannung $V_M$. In der zweiten Zeile in Fig. 3 ist außerdem die konstante Referenzspannung Vref dargestellt.

Während das Stromschaltelement 11 gesperrt ist und der Strom $I_L$ durch den zweiten Schaltungszweig 3 fließt, nimmt dieser Strom $I_L$ und mithin die Meßspannung $V_M$ allmählich ab. Wenn der Wert der Meßspannung $V_M$ den Wert der Referenzspannung Vref erreicht, was gemäß Fig. 3 zum Zeitpunkt t2 der Fall ist, ändern sich die Vorzeichenverhältnisse an den beiden Eingängen des Vergleichers 20, so daß sich folglich der Pegel des am Ausgang des Vergleichers erscheinenden Vorzeichensignals S ändert. Durch diesen Pegelwechsel des Signals am Eingang S des RS-Flipflops 22 wird das Flipflop umgeschaltet, so daß am Ausgang Q ein hoher Pegel des PWM-Stellsignals gebildet wird, durch den das Stromschaltelement 11 geöffnet wird. Hierdurch sinkt die Spannung Vout am zweiten Anschluß 2 schlagartig auf Null (genauer gesagt: auf annähernd Null, wenn man den Einschaltwiderstand Ron des Stromschaltelements 11 berücksichtigt).

Während das Stromschaltelement geöffnet ist, fließt der Strom durch den ersten Schaltungszweig 4, wobei sich die Stromstärke allmählich erhöht, wie in dem Zeitintervall zwischen den Zeitpunkten t2 und t3 in der dritten Zeile der Fig. 3 dargestellt ist. Es handelt sich also bei dieser Ausführungsform um eine relativ einfach zu realisierende Minimum-Regelung, wobei der Minimum-Strom $I_{Lmin}$ über die Referenzstromquelle 15 eingestellt wird. Anhand der Fig. 3 läßt sich auch ersehen, daß bei zu großem Strom in der induktiven Last 6 aufgrund der dann höheren Meßspannung $V_M$ eine längere Zeitspanne benötigt wird, bis die Spannung $V_M$ auf den Wert von Vref abgesunken ist. In dieser längeren Zeitspanne kann dann der zu hohe Strom entsprechend weit bis auf den Minimum-Strom absinken.

Bei der oben beschriebenen Ausführungsform nach Fig. 1 sind ein ohmscher Meßwiderstand 9 und dementsprechend ein ohmscher Referenzwiderstand 14 vorgesehen. Insbesondere dann, wenn die Messung nicht so genau sein muß, kann man statt des Ohmschen Meßwiderstands einen anderen Meßumformer verwenden, insbesondere ein Bauelement mit einer nicht-linearen Spannungs/Strom-Kennlinie. Bei einem solchen Bauelement läßt sich die Verlustleistung in dem zweiten Schaltungszweig weiter verringern. Fig. 15 zeigt eine alternative Ausführungsform mit zwei abgeänderten Schaltungszweigen 3' und 13'. In dem zweiten Schaltungszweig 3' befindet sich als Meßumformer eine Diode 9', die die Meßspannung $V_M$ liefert. In dem vierten Schaltungszweig 13' befindet sich eine Referenzdiode 14', die die Referenzspannung Vref liefert.

Die Ausbildung von Dioden mit im wesentlichen gleichen Kennlinien ist nur mit größeren Toleranzen möglich als die Ausbildung von ohmschen Widerständen. Allerdings wird mit der etwas schlechteren Genauigkeit beim Bilden der Meßspannung und der Referenzspannung eine verringerte Verlustleistung erkauft. Als weitere Abwandlung kann anstelle der Meßdiode 9' auch die Freilaufdiode selbst zur Bildung der Meßspannung herangezogen werden.

Fig. 4 zeigt eine zweite Version der Ausführungsform nach Fig. 1 der erfindungsgemäßen Schaltungsvorrichtung. Bei der zweiten Version der ersten Ausführungsform enthält die PWM-Schaltung 10B einen Auf/Ab-Zähler 23 mit einem Aufwärts/Abwärts-Setzeingang, dem das Vorzeichensignal S von dem Vergleicher 20 zugeführt wird, einem Takteingang und einem Ausgang, der mit einem Eingang eines Digitalvergleichers (Comp) 25 verbunden ist, ferner einen Rampenzähler 24, der mit einem zweiten Eingang des Digitalvergleichers 25 verbunden ist, und ein UND-Gatter 26.

Die in Fig. 4 dargestellten Schaltungskomponenten sind an sich bekannte Bauteile, deren Funktionsweise dem Fachmann bekannt ist. Das Eingangssignal $CLK_{INB}$ wird dem Takteingang des Rampenzählers zugeführt, so daß der Rampenzähler relativ schnell von Null bis auf seinen Maximalwert hochzählt und dabei an dem Ausgang ein digitales Rampensignal erzeugt. Nach Ablauf einer von der Taktfrequenz und der Stellenzahl des Zählers abhängigen Periodendauer fängt der Zähler wieder bei Null an, erneut hochzuzählen. Das Taktsignal $CLK_{INB}$ wird über das UND-Gatter 26 auf den Takteingang des Auf/Ab-Zählers 23 gegeben. Das UND-Gatter 26 wird von dem invertierten PWM-Stellsignal geöffnet.

Der Zählerstand des Auf/Ab-Zählers 23 ändert sich abhängig von der Änderung des Vorzeichensignals S langsam nach oben oder nach unten. Besteht Gleichheit zwischen dem Ausgangssignal des Auf/Ab-Zählers 23 und dem sich demgegenüber rasch ändernden Rampensignal am Ausgang des Rampenzählers 24, erfolgt ein Umschalten des Pegels am Ausgang des Digitalvergleichers 25, wodurch das PWM-Stellsignal für den Steueranschluß 12 des Stromschaltelements 14 gebildet wird.

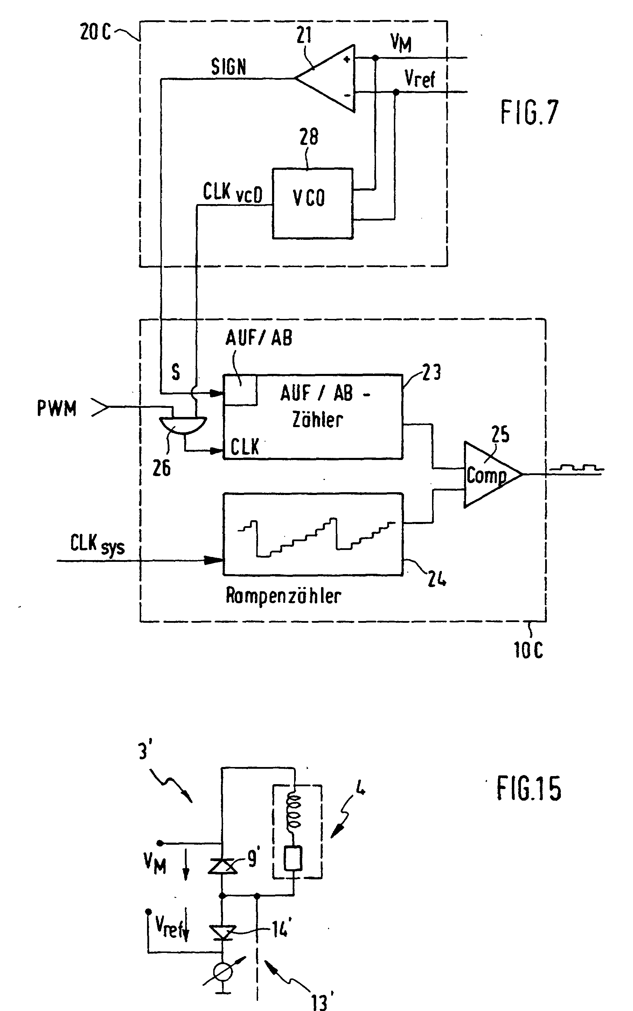

Fig. 7 ist ein Blockschaltbild einer ersten Version einer zweiten Ausführungsform der erfindungsgemäßen Schaltungsvorrichtung. Die Ausführungsform nach Fig. 7 ähnelt der Ausführungsform nach Fig. 3 bezüglich der PWM-Schaltung. Die PWM-Schaltung 10C gemäß Fig. 7 ist ähnlich aufgebaut und funktioniert ähnlich wie die PWM-Schaltung 10B nach Fig. 4, nur daß die den Zählern 23 und 24 zugeführten Taktsignale anders sind, wie im folgenden näher erläutert wird.

Dem Rampenzähler 24 der PWM-Schaltung 10C nach Fig. 7 wird ein Systemtaktsignal CLKsys zugeführt, welches eine konstante Frequenz von zum Beispiel 4 kHz haben kann. Insofern ist der Betrieb des Rampenzählers identisch mit dem Betrieb des Rampenzählers 24 in Fig. 4.

Dem Auf/Ab-Zähler 23 der PWM-Schaltung 10C wird aber kein konstantes Taktsignal, das heißt ein Taktsignal mit konstanter Frequenz zugeführt, sondern dem Takteingang des Auf/Ab-Zählers 23 wird ein Taktsignal veränderlicher Frequenz $CLK_{VCO}$ zugeführt. Hierzu ist in dem Vergleicher 20C gemäß Fig. 7 außer dem OP-Verstärker 21, der das Vorzeichensignal S liefert, noch ein spannungsgesteuerter Oszillator (VCO) 28 enthalten, der als Eingangsspannung die Differenzspannung aus der Meßspannung $V_M$ und der Referenzspannung Vref empfängt und abhängig von dieser Differenzspannung ein Ausgangs-Schwingungssignal oder Ausgangs-Impulssignal veränderlicher Frequenz erzeugt. Bei starkem Unterschied zwischen $V_M$ und Vref ist die Frequenz des Ausgangssignals $CLK_{VCO}$ des VCO 28 relativ hoch, so daß dementsprechend - bei geöffnetem UND-Gatter 26 - der Auf/Ab-Zähler 23 relativ schnell zählt (abhängig vom Vorzeichensignal S nach oben oder nach unten). Bei Annäherung der beiden Spannungen $V_M$ und Vref wird die Frequenz des Taktsignals $CLK_{VCO}$ am Ausgang des VCO 28 geringer, so daß dementsprechend der Auf/Ab-Zähler 23 langsamer zählt. Dieser Ablauf bedeutet, daß bei einer starken Regelabweichung der Auf/Ab-Zähler sehr schnell zählt, also für eine rasche Annäherung des Ist-Stromwerts an den Soll-Stromwert gesorgt wird, daß aber bei geringer Regelabweichung entsprechend langsam nachgeregelt wird, wodurch Überschwinger vermieden werden oder gering gehalten werden.

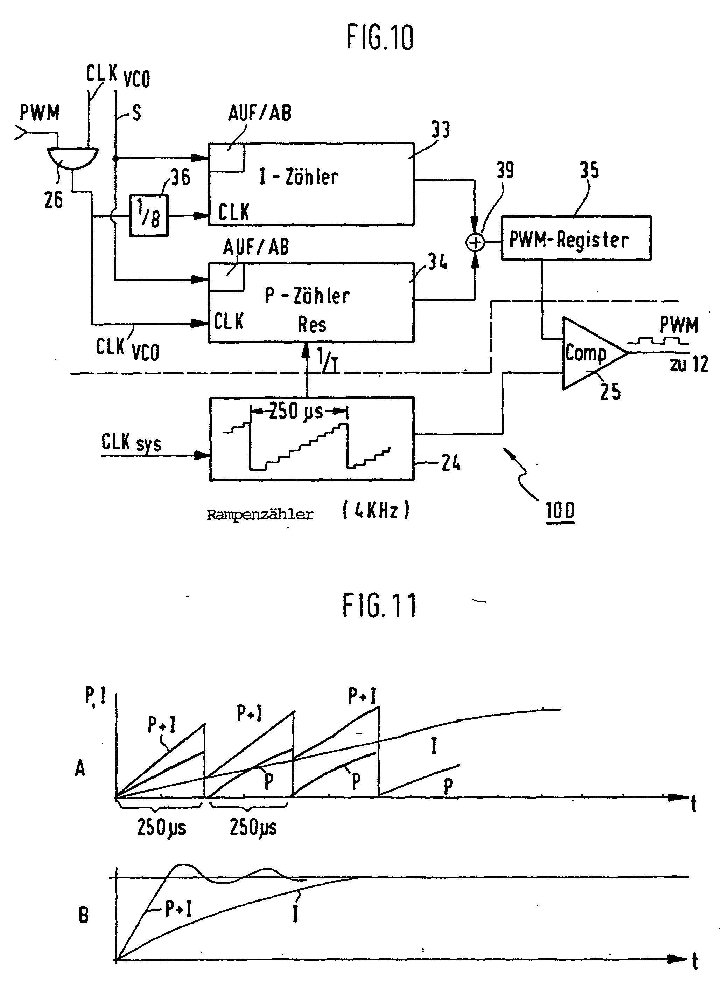

Fig. 10 ist ein Blockschaltbild einer zweiten Version der zweiten Ausführungsform der Erfindung. Die Eingangssignale links oben in der Schaltung nach Fig. 10 sind die gleichen wie bei der Schaltung nach Fig. 7. Der Vergleicher, der die Signale S (Vorzeichensignal) bzw. $CLK_{VCO}$ liefert, ist der gleiche wie der in Fig. 7 dargestellte Vergleicher 20C.

Der Unterschied zwischen der Schaltung nach Fig. 10 und der Schaltung nach Fig. 7 besteht darin, daß der Auf/Ab-Zähler 23 aus Fig. 7 mehrteilig ausgeführt ist. Anstelle eines einzelnen Auf/Ab-Zählers enthält die PWM-Schaltung 10D nach Fig. 10 einen hier als I-Zähler oder Integralzähler bezeichneten ersten Auf/Ab-Zähler 33 und einen als P-Zähler oder Proportionalzähler bezeichneten, zweiten Auf/Ab-Zähler 34, deren Ausgänge mit zwei Eingängen eines Addierers 39 verbunden sind, und deren Takteingänge in der aus Fig. 10 ersichtlichen Weise mit der Taktsignalleitung verbunden sind.

Dem Takteingang des P-Zählers 34 wird über das bereits aus Fig. 3 und Fig. 7 bekannte UND-Gatter 26 das in der Frequenz veränderliche Taktsignal $CLK_{VCO}$ mit der ersten, veränderlichen Frequenz zugeführt. Dieses Taktsignal $CLK_{VCO}$ der ersten, veränderlichen Frequenz, wird auf einen Frequenzuntersetzer 36 gegeben, der die Frequenz des Taktsignals durch 8 dividiert und das in der Frequenz untersetzte Taktsignal dem Takteingang des I-Zählers 33 zuführt. Das dem Takteingang des I-Zählers zugeführte Taktsignal besitzt also eine dritte veränderliche Frequenz, die niedriger ist als die erste veränderliche Frequenz des Taktsignals $CLK_{VCO}$, wenn man die konstante Frequenz des Taktsignals CLKsys, die dem Takteingang des Rampenzählers 24 zugeführt wird, als zweite Frequenz bezeichnet.

Die Arbeitsweise der PWM-Schaltung 10D nach Fig. 10 ist ähnlich wie diejenige der Schaltung nach Fig. 7, nur daß das Ausgangssignal des Auf/Ab-Zählers 23 aus Fig. 7 ersetzt ist durch das Ausgangssignal des Addierers 39, der die Zählerstände des I-Zählers 33 und des P-Zählers 34 addiert und die Summe in ein PWM-Register 35 gibt. Dessen Inhalt wird von dem Digitalvergleicher 25 mit dem jeweiligen Zählerstand des Rampenzählers verglichen, um in der bereits erläuterten Weise am Ausgang das PWM-Stellsignal für den Steueranschluß 12 des Stromschalters 11 zu bilden.

Fig. 11 veranschaulicht schematisch die Arbeitsweise der Schaltung nach Fig. 10. Der Rampenzähler zählt mit relativ hochfrequentem Taktsignal CLKsys hoch und schaltet bei einer Periodendauer von 250 µs zurück. Dies entspricht einer Rampensignalfrequenz von 4 kHz. Mit dieser Frequenz wird der P-Zähler 34 von dem Rampenzähler 24 zurückgesetzt, wozu der Rampenzähler an den Rücksetzeingang RES des P-Zählers 34 ein Rücksetzsignal mit der Frequenz 1/T (= 4 kHz) liefert. Links in Fig. 11A ist die erste Periode entsprechend der Periodendauer des Rampenzählers dargestellt. Durch den Addierer 39 werden die Inhalte des I-Zählers 33 und des P-Zählers 34 addiert, wodurch sich die Summe P+I ergibt. Als Beispiel ist in Fig. 11 nicht der eingeschwungene Zustand dargestellt, sondern der Anfangszustand beim Hochregeln des Stroms. Das Hochzählen des P-Zählers hängt ab von der Taktfrequenz des Taktsignals $CLK_{VCO}$, und die Taktfrequenz hängt wiederum ab von der Differenz zwischen der Meßspannung $V_M$ und der Referenzspannung Vref. Mit zunehmend geringerer Differenz zwischen diesen beiden Spannungen zählt der P-Zähler 34 also immer langsamer, sodaß der Proportionalanteil P von Intervall zu Intervall geringer wird.

Demgegenüber zählt der I-Zähler 37 mit sich zwar ebenfalls ändernder, aber um das Achtfache geringerer Frequenz. Gemäß der Kurve I in Fig. 11A nimmt der Wert des I-Zählers allmählich zu, nähert sich aber allmählich einer Horizontalen.

In Fig. 11B ist das Summensignal P+I als Analogsignal dargestellt. Man erkennt das günstige Regelverhalten entsprechend dem Verlauf der Kurve P+I.

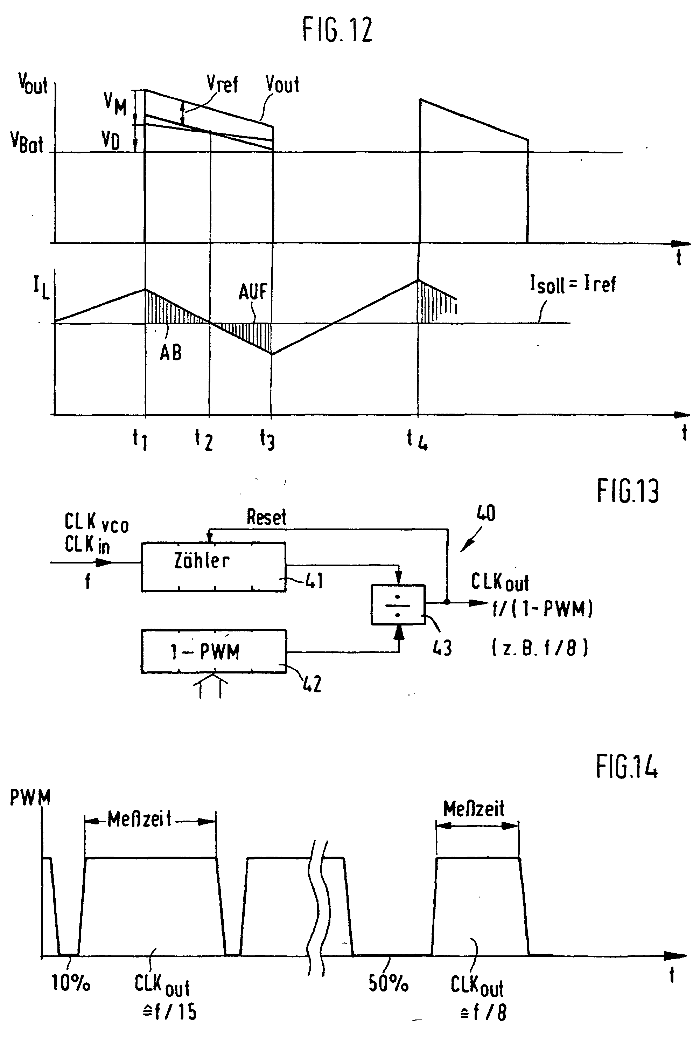

Um den Unterschied der Ausführungsform nach Fig. 10 gegenüber der Ausführungsform nach Fig. 3 zu erläutern, sei auf Fig. 12 Bezug genommen. Die Spannung Vout ändert sich sprunghaft mit dem Öffnen und dem Schließen des Stromschalters 11. Der zu regelnde Strom $I_L$ schwankt um den Soll-Strom, der dem Referenzstrom Iref entspricht. In dem Intervall zwischen den Zeitpunkten t1 und t3 erfolgt entsprechend dem Ausgangssignal des Addierers 39, das heißt entsprechend dem Inhalt des PWM-Registers 35 ein Abwärtszählen. In dem dann anschließenden Intervall zwischen den Zeitpunkten t2 und t3 erfolgt ein Aufwärtszählen. Der Wechsel der Zählrichtung in dem I-Zähler 33 und dem P-Zähler 34 hängt ab von dem Zeitpunkt, zu dem die Meßspannung $V_M$ der Referenzspannung Vref gleicht. In der oberen Zeile in Fig. 12 ist zusätzlich noch die Durchlaßspannung der Diode, $V_D$, dargestellt.

Bei den oben dargestellten PWM-Schaltungen, die mit Zählern arbeiten, wird innerhalb der gesamten Impulspause gemessen. Diese Situation ist in Fig. 14 dargestellt. Fig. 14 zeigt die Impulspausen des PWM-Stellsignals als hohe Pegel, die Impulse selbst als niedrige Pegel. Ist die Impulspause jeweils groß, so ist entsprechend die Meßzeit lang, wie in Fig. 14 dargestellt ist. Um innerhalb unterschiedlicher Meßzeiten vergleichbare Ergebnisse mit den Zählern zu erhalten, ist erfindungsgemäß eine Meßzeitkompensation vorgesehen. Diese Meßzeitkompensation sorgt dafür, daß in einer relativ langen Meßzeit, wie sie links in Fig. 14 dargestellt ist, mit einer relativ niedrigen Taktfrequenz gezählt wird, während bei relativ kurzer Meßzeit, wie sie in Fig. 14 rechts dargestellt ist, mit einer relativ hohen Taktfrequenz gezählt wird. Durch entsprechende Wahl der Frequenz des Taktsignals läßt sich erreichen, daß unabhängig von der jeweiligen Meßzeit stets gleiche Anzahlen von Taktimpulsen gezählt werden.

Fig. 13 zeigt eine bevorzugte Ausführungsform einer Meßzeit-Kompensationsschaltung 40. Die Schaltung 40 enthält einen Zähler 41 mit einem Takteingang, einem Rücksetzeingang R und einem Ausgang, ein Divisor-Register 42, in welchem ein Wert entsprechend (1-PWM) laufend neu abgespeichert wird, und eine Teilerschaltung 43 mit zwei Eingängen und einem Ausgang.

Der Zähler 41 zählt mit einem konstanten Eingangs-Taktsignal CLKin oder einem veränderlichen Eingangs-Taktsignal $CLK_{VCO}$ periodisch hoch, um von einem Rücksetzsignal am Ausgang der Teilerschaltung 43 zurückgesetzt zu werden. Die Teilerschaltung 43 empfängt das Signal vom Ausgang des Zählers 41 an ihrem Dividendeneingang und empfängt den Inhalt des Divisor-Registers 42 an ihrem Divisor-Ausgang und liefen ein Quotienten-Signal als Taktsignal CLKout an ihren Ausgang. Das Taktsignal CLKout hat die Frequenz f/(1-PWM).

Wenn der zum Beispiel vierstellige Inhalt des Divisor-Registers 42 mit seinen möglichen Inhalten 1, 2...15 geladen ist, wird die Frequenz des Eingangs-Taktsignals CLKin des Zählers 41 entsprechend durch 1, 2... bzw. 15 dividiert. Dementsprechend wird die Frequenz des Ausgangssignals CLKout untersetzt. Bei einem geringen Tastverhältnis und entsprechend geringer Impulsdauer des PWM-Stellsignals ist aufgrund der dann langen Impulspause die Meßzeit sehr groß, wie links in Fig. 14 dargestellt ist. Dementsprechend würde bei dieser maximal langen Meßzeit eine Division der Eingangsfrequenz durch fünfzehn erfolgen, so daß die Frequenz des Ausgangssignals CLKout dann f/15 betragen würde. Bei mittellanger Meßzeit würde eine Division durch acht erfolgen, so daß das Ausgangs-Taktsignal CLKout eine Frequenz von f/8 hätte.

Die oben beschriebene Meßzeit-Kompensationsschaltung läßt sich auch bei Steuer- und Regelschaltungen einsetzen, die nicht speziell für induktive Lasten ausgelegt sind, sondern die zum Regeln und Steuern beliebiger Lasten mit Hilfe eines PWM-Stellsignals ausgelegt sind und einen oder mehrere Zähler beinhalten, wobei in Verbindung mit einem Meßvorgang eine Zählung innerhalb eines veränderlichen Zeitintervalls durchgeführt wird.

Die Erfindung ist nicht auf die oben beschriebenen speziellen Ausführungsbeispiele und deren verschiedene Versionen beschränkt, sondern im Rahmen der Patentansprüche sind sämtliche Abwandlungen möglich, die dem Fachmann aufgrund seines Fachwissens ersichtlich sind.

**Patentansprüche**

1. Schaltungsvorrichtung zum Regeln einer induktiven Last (6), umfassend folgende Merkmale:

   a) einen ersten Schaltungszweig (4) zwischen einem ersten Anschluß (1) und einem zweiten Anschluß (2), mit der zu regelnden induktiven Last (6);
   b) einen zweiten Schaltungszweig (3, 3') zwischen dem ersten Anschluß (1) und dem zweiten Anschluß (2), mit einer Freilaufdiode (8);
   c) einen dritten Schaltungszweig (5) zwischen dem ersten und dem zweiten Schaltungszweig einerseits und einem dritten Anschluß (GND) andererseits, mit einem elektronischen Stromschaltelement (11), das einen Steueranschluß (12) aufweist, dem ein PWM-Stellsignal zugeführt wird;
   d) einen Stromfühler (9, 9') zum Fühlen eines Stroms, der abhängt von dem durch die induktive Last (6) fließenden Strom (IL), und zum Erzeugen einer einen Strom - Istwert repräsentierenden Meßspannung (VM); und
   e) eine Regelschaltung (10, 13, 14, 14', 15, 20), die als erstes Eingangssignal die Meßspannung (VM) und als zweites Eingangssignal eine einen Strom - Sollwert repräsentierende Referenzspannung (Vref) empfängt, um daraus das PWM-Stellsignal (PWM; PWM (Gate)) zu bilden;
   f) wobei der Stromfühler (9) in dem zweiten Schaltungszweig (3) angeordnet ist,

   **dadurch gekennzeichnet, daß**
   an den zweiten Schaltungszweig (3) ein vierter Schaltungszweig (13, 13') angeschlossen ist, der ein Referenzelement (14, 14') und eine Referenzstromquelle (15) enthält; wobei das Referenzelement (14, 14') vom Strom der Referenzstromquelle (15) durchflossen wird, um die Referenzspannung (Vref) zu erzeugen.

2. Schaltungsvorrichtung nach Anspruch 1, bei der der Stromfühler (9) ein ohmscher Meßwiderstand (9; RM3) ist, der zu der Freilaufdiode (8) in Reihe geschaltet ist.

3. Schaltungsvorrichtung nach Anspruch 1, bei der der Stromfühler ein eine nicht-lineare Kennlinie aufweisendes Bauelement, insbesondere eine Diode (9') ist.

4. Schaltungsvorrichtung nach Anspruch 1, 2 oder 3, mit einem Vergleicher (20), der die Referenzspannung (Vref) mit der Meßspannung (VM) vergleicht und ein von dem Vergleich abhängiges Vorzeichensignal (S) erzeugt.

5. Schaltungsvorrichtung nach Anspruch 4, mit einem RS-Flipflop (22), dessen Setzeingang das Vorzeichensignal (2) zugeführt wird, dessen Rücksetzeingang ein die Frequenz des PWM-Stellsignals definierendes Taktsignal (CLKINA) zugeführt wird, und dessen Ausgang (Q) mit dem Steueranschluß (12) des Stromschaltelements (11) verbunden ist.

6. Schaltungsvorrichtung nach Anspruch 4, umfassend:

   a) einen Auf/Ab-Zähler (23; 33, 34, 39) mit einem Auf/Ab-Steuereingang, dem das Vorzeichensignal (S) zugeführt wird, mit einem Takteingang, dem ein Taktsignal mit einer ersten Frequenz zugeführt wird, und mit einem Zählerstands-Ausgang;
   b) einen Rampenzähler (24) mit einem Takteingang, dem ein Taktsignal mit einer zweiten Frequenz zugeführt wird, und mit einem Zählerstands-Ausgang; und
   c) einen Digitalvergleicher (25) mit einem ersten Eingang, der mit dem Zählerstands-Ausgang des Auf/Ab-Zählers (23; 33, 34, 39, 35) verbunden ist, mit einem zweiten Eingang, der mit dem Zählerstands-Ausgang

**EP 1 050 894 B1**

des Rampenzählers (24) verbunden ist, und mit einem Ausgang, der mit dem Steueranschluß (12) des Stromschaltelements (11) verbunden ist.

**7.** Schaltungsvorrichtung nach Anspruch 6, bei der die erste Frequenz mit der zweiten Frequenz identisch ist.

**8.** Schaltungsvorrichtung nach Anspruch 6, mit einem spannungsgesteuerten Oszillator (28) mit zwei Eingangsanschlüssen, denen die Meßspannung (VM) bzw. die Referenzspannung (Vref) zugeführt wird, und mit einem Ausgang, der mit dem Takteingang des Auf/Ab-Zählers (23; 33, 34, 39, 35) verbunden ist, um diesem als Taktsignal der ersten Frequenz das in der Frequenz veränderliche Ausgangssignal (CLKVCO) des spannungsgesteuerten Oszillators (28) zuzuführen.

**9.** Schaltungsvorrichtung nach einem der Ansprüche 6 bis 8, bei der dem Takteingang des Auf/Ab-Zählers ein Gatter (26) vorgeschaltet ist, welches das dem Takteingang zugeführte Taktsignal während der Impulszeiten des PWM-Stellsignals sperrt.

**10.** Schaltungsvorrichtung nach einem der Ansprüche 6 bis 9, bei der der Auf/Ab-Zähler aufweist:

a) einen ersten, als I- oder Integralzähler bezeichneten Auf/Ab-Zählerteil (33);
b) einen zweiten, als P- oder Proportionalzähler bezeichneten Auf/Ab-Zählerteil (34);
c) ein PWM-Register (35) mit einem Eingang und einem Ausgang; und
d) einen Addierer (39) mit zwei Eingängen, die an den Ausgang des I-Zählerteils bzw. an den Ausgang des P-Zählerteils (34) angeschlossen sind, und mit einem Ausgang, der an den Eingang des PWM-Registers (35) angeschlossen ist,
e) wobei der Ausgang des PWM-Registers (35) an den einen Eingang des Digitalvergleichers (25) angeschlossen ist, dem Takteingang des P-Zählerteils (34) das Taktsignal mit der ersten Frequenz zugeführt wird, dem Takteingang des I-Zählerteils (33) ein Taktsignal mit einer dritten Frequenz, die vorzugsweise niedriger ist als die erste Frequenz, zugeführt wird, und wobei der P-Zählerteil (34) einen Rücksetzeingang (RES) aufweist, der mit dem Rampenzähler (34) verbunden ist und von diesem bei jeder Rampenperiode ein Rücksetzsignal empfängt.

**11.** Schaltungsvorrichtung nach Anspruch 10,
**dadurch gekennzeichnet, daß** dem Takteingang des I-Zählerteils ein Frequenzteiler (36) vorgeschaltet ist, der das Taktsignal der ersten Frequenz (CLKVCO) empfängt und dieses in das Taktsignal der dritten Frequenz umsetzt.

**12.** Schaltungsvorrichtung nach einem der Ansprüche 6 bis 11, mit einer Meßzeit-Kompensationsschaltung (40), die das Taktsignal der ersten Frequenz, welches dem Takteingang des Auf/Ab-Zählers zugeführt wird, in Abhängigkeit des Tastverhältnisses des PWM-Stellsignals in der Weise untersetzt, daß bei großem Tastverhältnis, mithin bei langer Meßzeit, eine relativ starke Untersetzung erfolgt, und bei kleinem Tastverhältnis nur eine relativ schwache Untersetzung er folgt.

**13.** Schaltungsvorrichtung nach Anspruch 12, bei der die Meßzeit-Kompensationsschaltung (40) aufweist:

a) einen rücksetzbaren Zähler (41) mit einem Eingang, der ein Eingangstaktsignal mit einer Eingangsfrequenz empfängt, mit einem Zählerausgang und mit einem Rücksetzeingang (R),
b) ein Divisor-Register (42) mit einem Ausgang und einem Setzeingang, über den ein Digitalwert einstellbar ist, der in umgekehrtem Verhältnis zu dem Tastverhältnis des PWM-Stellsignals steht, und
c) eine Teilerschaltung (43) mit einem Dividenden-Eingang, der mit dem Ausgang des Zählers (41) verbunden ist, mit einem Divisor-Eingang, der mit dem Ausgang des Divisor-Registers (42) verbunden ist, und mit einem Ausgang, der das Taktsignal mit der ersten Frequenz an den Takteingang des Auf/Ab-Zählers gibt, wobei die erste Frequenz dem Quotienten aus der Eingangsfrequenz und dem Divisor entspricht.

**Claims**

**1.** A circuit arrangement for controlling an inductive load (6), comprising:

a) a first circuit branch (4) located between a first terminal (1) and a second terminal (2) and including the inductive load (6) to be controlled;

b) a second circuit branch (3, 3') located between the first terminal (1) and the second terminal (2) and including a flyback diode (8);

c) a third circuit branch (5) located between the first and second circuit branches on the one hand and a third terminal (GND) on the other hand and including an electronic current switching element (11) having a control terminal (12) to which a PWM control signal is supplied;

d) a current sensor (9, 9') for sensing a current dependent on the current (IL) flowing through the inductive load (6), and for generating a measurement voltage representing an actual current value (VM); and

e) a closed-loop control circuit (10, 13, 14, 14', 15, 20) receiving as first input signal the measurement voltage (VM) and as second input signal a reference voltage representing a desired current value (Vref) in order to form thereof the PWM control signal (PWM; PWM (Gate));

f) the current sensor (9) being arranged in the second circuit branch (3),

**characterized in that** the second circuit branch (3) has a fourth circuit branch (13, 13') connected thereto which contains a reference element (14, 14') and a reference current source (15); the reference element (14, 14') having the current of the reference current source (15) flowing therethrough in order to generate the reference voltage (Vref).

2. The circuit arrangement of claim 1,
wherein the current sensor (9) is an ohmic measuring resistor (9; RM3) connected in series with the flyback diode (8).

3. The circuit arrangement of claim 1,
wherein the current sensor is a component having a non-linear characteristics, in particular a diode (9').

4. The circuit arrangement of claim 1, 2 or 3,
comprising a comparator (20) comparing the reference voltage (Vref) to the measurement voltage (VM) and generating a sign signal (S) as a function of the comparison.

5. The circuit arrangement of claim 4,
comprising an RS flipflop (22) having the sign signal (2) supplied to the setting input thereof and having a clock signal (CLKINA), which defines the frequency of the PWM control signal, applied to the resetting input thereof and having its output (Q) connected to the control terminal (12) of the current switching element (11).

6. The circuit arrangement of claim 4, comprising:

a) an up/down counter (23; 33, 34, 39) having an up/down control input to which the sign signal (S) is supplied, a clock input to which a clock signal of a first frequency is supplied, as well as a count output;

b) a ramp counter (24) having a clock input to which a clock signal of a second frequency is supplied, and a count output; and

c) a digital comparator (25) having a first input connected to the count output of the up/down counter (23; 33, 34, 39, 35), a second input connected to the count output of the ramp counter (24), and an output connected to the control terminal (12) of the current switching element (11).

7. The circuit arrangement of claim 6,
wherein the first frequency is identical with the second frequency.

8. The circuit arrangement of claim 6,
comprising a voltage-controlled oscillator (28) having two input terminals receiving the measurement voltage (VM) and the reference voltage (Vref), respectively, and an output connected to the clock input of the up/down counter (23; 33, 34, 39, 35) in order to supply thereto, as clock signal of the first frequency, the frequency-variable output signal (CLKVCO) of the voltage-controlled oscillator (28).

9. The circuit arrangement of any of claims 6 to 8,
wherein the clock input of the up/down counter has a gate (26) connected upstream thereof which blocks the clock signal supplied to the clock input during the pulse times of the PWM control signal.

10. The circuit arrangement of any of claims 6 to 9,

wherein the up/down counter comprises:

a) a first up/down counter part (33) referred to as I or integral counter;
b) a second up/down counter part (34) referred to as P or proportional counter;
c) a PWM register (35) having an input and an output; and
d) an adder (39) having two inputs connected to the output of the I counter part and to the output of the P counter part (34), respectively, and an output connected to the input of the PWM register (35),
e) the output of the PWM register (35) being connected to one input of the digital comparator (25), the clock input of the P counter part (34) being fed with the clock signal of the first frequency, the clock input of the I counter part (33) being fed with a clock signal of a third frequency that is preferably lower than the first frequency, and the P counter part (34) having a resetting input (RES) connected to the ramp counter (34) and receiving from the same a resetting signal in each ramp period.

**11.** The circuit arrangement of claim 10,
**characterized in that** the clock input of the I counter part has a frequency divider (36) connected upstream thereof which receives the clock signal of the first frequency (CLKVCO) and converts the same to the clock signal of the third frequency.

**12.** The circuit arrangement of any of claims 6 to 11,
comprising a measuring time compensation circuit (40) which scales down the clock signal of the first frequency, supplied to the clock input of the up/down counter, in accordance with the duty cycle of the PWM control signal in such a manner that, with high duty cycle and consequently long measuring time, relatively strong scaling down is effected whereas with low duty cycle only relatively weak scaling down is effected.

**13.** The circuit arrangement of claim 12,
wherein the measuring time compensation circuit (40) comprises:

a) a resettable counter (41) having an input receiving an input clock signal with an input frequency, and having a counter output and a resetting input (R);
b) a divisor register (42) having an output and a setting input via which a digital value is adjustable that is in inverse ratio to the duty cycle of the PWM control signal, and
c) a divider circuit (43) having a dividend input connected to the output of the counter (41), a divisor input connected to the output of the divisor register (42), and an output passing the clock signal of the first frequency to the clock input of the up/down counter, with the first frequency corresponding to the quotient of the input frequency and the divisor.

**Revendications**

**1.** Circuit de réglage d'une charge inductive (6) comprenant les caractéristiques suivantes :

a) une première branche de circuit (4) entre une première borne (1) et une deuxième borne (2), avec la charge inductive (6) à régler,

b) une deuxième branche de circuit (3, 3') entre la première borne (1) et la deuxième borne (2), avec une diode de roue libre (8),

c) une troisième branche de circuit (5) entre la première et la deuxième branche de circuit d'une part et une troisième borne (GND) d'autre part, avec un élément électronique de commutation du courant (11) qui comporte une gâchette (12) vers laquelle est conduit un signal de commande à modulation d'impulsions en largeur,

d) un détecteur de courant (9, 9') pour la détection d'un courant qui dépend du courant (IL) traversant la charge inductive (6) et pour la production d'une tension de mesure représentant une valeur réelle du courant (VM) et

e) un circuit de réglage (10, 13, 14, 14', 15, 20) qui reçoit la tension de mesure (VM) en tant que premier signal d'entrée et une tension de référence représentant une valeur théorique du courant (vref) en tant que deuxième signal d'entrée afin de former à partir de cela le signal de commande à modulation d'impulsions en largeur (PWM, PMW (Gate)),

EP 1 050 894 B1

f) le détecteur de courant (9) étant disposé dans la deuxième branche de circuit (3),

**caractérisé en ce qu'**à la deuxième branche de circuit (3) est raccordée une quatrième branche de circuit (13, 13') qui comporte un élément de référence (14, 14') et une source de courant de référence (15), l'élément de référence (14, 14') étant traversé par le courant de la source de courant de référence (15), afin de produire la tension de référence (vref).

2. Circuit selon la revendication 1, dans lequel le détecteur de courant (9) est une résistance pure de mesure (9, RM3) qui est montée en série avec la diode de roue libre (8).

3. Circuit selon la revendication 1, dans lequel le détecteur de courant est un composant comportant une courbe caractéristique non linéaire, en particulier une diode (9').

4. Circuit selon la revendication 1, 2 ou 3, avec un comparateur (20) qui compare la tension de référence (vref) à la tension de mesure (VM) et produit un signal (S) dépendant de la comparaison.

5. Circuit selon la revendication 4, avec une bascule RS (22) dont l'entrée de réglage reçoit le signal (2), dont l'entrée de réinitialisation reçoit un signal d'horloge (CLKINA) définissant la fréquence du signal de réglage PWM et dont la sortie (Q) est reliée à la gâchette (12) de l'élément de commutation du courant (11).

6. Circuit selon la revendication 4, comprenant :

a) un compteur progressif/dégressif (23, 33, 34, 39) avec une entrée de commande progressive/dégressive qui reçoit le signal (S), avec une entrée d'horloge qui reçoit un signal d'horloge avec une première fréquence et avec une sortie de position de compteur,

b) un compteur de rampe (24) avec une entrée d'horloge qui reçoit un signal d'horloge avec une deuxième fréquence et avec une sortie de position de compteur et

c) un comparateur numérique (25) avec une première entrée qui est reliée à la sortie de position du compteur progressif/dégressif (23, 33, 34, 39, 35) avec une deuxième entrée qui est reliée à la sortie de position du compteur de rampe (24) et avec une sortie qui est reliée à la gâchette (12) de l'élément de commutation de courant (11).

7. Circuit selon la revendication 6, dans lequel la première fréquence est identique à la deuxième fréquence.

8. Circuit selon la revendication 6, avec un oscillateur commandé par tension (28) avec deux raccordements d'entrée, lesquels reçoivent la tension de mesure (VM) ou la tension de référence (vref), et avec une sortie qui est reliée à l'entrée d'horloge du compteur progressif/dégressif (23, 33, 34, 39, 35), pour amener vers ce dernier, en tant que signal d'horloge de la première fréquence, le signal de sortie (CLKVCO) variable dans la fréquence de l'oscillateur commandé par tension (28).

9. Circuit selon l'une quelconque des revendications 6 à 8, dans lequel une grille (26) est reliée, en amont, à l'entrée d'horloge du compteur progressif/dégressif, grille qui bloque le signal d'horloge amené vers l'entrée d'horloge pendant les temps d'impulsion du signal de réglage PWM.

10. Circuit selon l'une des revendications 6 à 9, dans lequel le compteur progressif/dégressif, comprend :

a) une première partie de compteur progressif/dégressif (33) dénommée compteur I ou intégral,

b) une deuxième partie de compteur progressif/dégressif (34) dénommée compteur P ou proportionnel,

c) un registre PWM (35) avec une entrée et une sortie et

d) un circuit d'addition (39) avec deux entrées, qui sont raccordées à la sortie de la partie de compteur I ou à la sortie de la partie de compteur P (34), et avec une sortie qui est raccordée à l'entrée du registre PWM (35),

e) le registre PWM (35) étant raccordée à l'entrée du comparateur numérique (25), l'entrée d'horloge de la

15

partie de compteur P (34) reçoit le signal d'horloge avec la première fréquence, l'entrée d'horloge de la partie de compteur 1 (33) reçoit un signal d'horloge avec une troisième fréquence qui est de préférence plus faible que la première fréquence et la partie de compteur P (34) comprenant une entrée de réinitialisation (RES) qui est reliée au compteur de rampe (34) et qui reçoit de celui-ci un signal de réinitialisation pour chaque période de rampe.

**11.** Circuit selon la revendication 10, **caractérisé en ce qu'**est relié, en amont, à l'entrée d'horloge de la partie de compteur I, un diviseur de fréquence (36) qui reçoit le signal d'horloge de la première fréquence (CLKVCO) et convertit ce signal en un signal d'horloge de la troisième fréquence.

**12.** Circuit selon l'une quelconque des revendications 6 à 11, avec un circuit d'horloge du temps de mesure (40) qui démultiplie le signal d'horloge de la première fréquence, lequel signal est amené vers l'entrée d'horloge du compteur progressif/dégressif, en fonction de la durée du cycle du signal de réglage PWM de telle sorte que, pour une longue durée de cycle, donc lors d'un long temps de mesure, il se produise une démultiplication relativement forte et, lors d'une courte durée de cycle, il se produise uniquement une démultiplication relativement faible.

**13.** Circuit selon la revendication 12, dans lequel le circuit de compensation du temps de mesure (40) comprend :

a) un compteur pouvant être remis à zéro (41) avec une entrée qui reçoit un signal d'horloge d'entrée avec une fréquence d'entrée, avec une sortie de compteur et avec une entrée de réinitialisation (R),

b) un registre diviseur (42) avec une sortie et une entrée de réglage par le biais de laquelle il est possible de régler une valeur numérique qui est en rapport inversé relativement à la durée du cycle du signal de réglage PWM et

c) un circuit diviseur (43) avec une entrée dividende qui est reliée à la sortie du compteur (41), avec une entrée du diviseur qui est reliée à la sortie du registre diviseur (42) et avec une sortie qui transmet le signal d'horloge avec la première fréquence à l'entrée d'horloge du compteur progressif/dégressif, la première fréquence correspondant au quotient tiré de la fréquence de sortie et du diviseur.

# FIG.1

# FIG.2

# FIG. 3

# FIG. 4

FIG.5

FIG.6

EP 1 050 894 B1

FIG.7

FIG.15

## FIG. 8

## FIG. 9

## FIG.10

## FIG.11

FIG. 12

FIG.13

FIG.14